# EUROPEAN PATENT APPLICATION

(11) **EP 4 769 882 A1**
(43) Date of publication of application: **01.07.2026**
(21) Application number: 25808404.5
(22) Date of filing: 21.04.2025
(51) Int. Cl.: H02J 7/00, G01R 19/165, G01R 31/382

(54) **APPARATUS AND METHOD FOR CONTROLLING BATTERY**

(30) Priority: 22.05.2024 KR 20240066209; 18.04.2025 KR 20250050649
(71) Applicant: LG Energy Solution, Ltd., Seoul 07335 (KR)
(72) Inventor: LEE, Chung Yong, Daejeon 34122 (KR); KIM, Yonghwan, Daejeon 34122 (KR)
(74) Representative: BCKIP Part mbB
(86) International application number: PCT/KR2025/095240
(87) International publication number: WO 2025/244490

(57) **Abstract**

An apparatus for controlling a battery according to one embodiment of the present invention is located in a battery system including a plurality of batteries, and may comprise: at least one processor; and memory storing at least one instruction that is executed through the at least one processor. The at least one instruction may comprise: an instruction for monitoring the voltages of online batteries, connected to a DC bus and being charged, during a charging process of the battery system; an instruction for disconnecting the connection between the DC bus and at least one battery, among the plurality of online batteries being charged, when the corresponding online battery satisfies a predefined target voltage, and thereby switching the corresponding online battery to an offline state; and an instruction for controlling cell balancing for at least one of the offline batteries switched to the offline state.

## Description

### [Technical Field]

This application claims priority to and the benefit of Korean Patent Application No.10-2024-0066209 filed in the Korean Intellectual Property Office on May 22, 2024 and Korean Patent Application No.10-2025-0050649 filed in the Korean Intellectual Property Office on April 18, 2025 the entire contents of which are incorporated herein by reference.

The present invention relates to a battery control apparatus and method, and more particularly, to a battery control apparatus and a method thereof for enhancing charging efficiency of a battery system.

### [Background Art]

Secondary batteries, capable of recharging and reuse, may be used as an energy source for small devices such as mobile phones, tablet PCs and vacuum cleaners, and also used as an energy source for medium and large devices such as automobiles and an energy storage system (ESS) for smart grids.

Secondary batteries may be applied to a system in a form of an assembly such as a battery module in which a plurality of battery cells is connected in series and parallel or a battery rack in which battery modules are connected in series and parallel according to system requirements. For medium and large-sized devices such as an energy storage system (ESS) for smart grids, a high-capacity battery system with multiple battery racks connected in parallel may be applied to satisfy required capacity of the device.

In general, a battery system has a disadvantage in that when one battery cell in a battery rack is fully charged, the charging process of the entire battery system including the corresponding battery rack is terminated even though other battery cells are not fully charged, which reduces charging efficiency of the battery system.

### [Detailed Description of the Invention]

### [Technical Problem]

To obviate one or more problems of the related art, embodiments of the present disclosure provide a battery control apparatus for improving stability of a battery system.

To obviate one or more problems of the related art, embodiments of the present disclosure also provide a battery control method performed by the battery control apparatus.

### [Technical Solution]

I n order to achieve the objective of the present disclosure, a battery control apparatus, located in a battery system including a plurality of batteries, may include at least one processor; and a memory configured to store at least one instruction executed by the at least one processor, and the at least one instruction may include an instruction to monitor a voltage of a plurality of online batteries which are connected to a direct current (DC) bus and being charged, during a charging process of the battery system; an instruction to switch at least one online battery, among the plurality of online batteries being charged, to an offline state by disconnecting the at least one corresponding online battery from the DC bus if the at least one corresponding online battery satisfies a predetermined target voltage; and an instruction to control cell balancing for at least one offline battery that has been switched to the offline state.

Here, the instruction to control cell balancing may include an instruction to control cell balancing of the at least one battery to be performed immediately after the at least one online battery is switched to an offline state.

In more detail, the instruction to control cell balancing may include an instruction to transmit a balancing mode switching signal to a battery management apparatus connected to the at least one offline battery, thereby controlling the battery management apparatus to perform cell balancing of the offline battery.

Meanwhile, according to an embodiment, the instruction to switch the at least one online battery to the offline state may include an instruction to, if any one of the plurality of online batteries being charged satisfies the predetermined target voltage, determine whether a corresponding online battery is a battery that has arrived at the predetermined target voltage again; and an instruction to transmit a switch control signal to a battery management apparatus connected to the corresponding online battery to disconnect the connection of the corresponding online battery to the DC bus if the corresponding online battery has arrived at the predetermined target voltage again.

Furthermore, the instruction to switch the at least one online battery to the offline state may include an instruction to transmit a charge rate control signal to a battery management apparatus connected to a corresponding online battery to adjust the charge rate of the corresponding online battery downward if the corresponding online battery reaches a predetermined target voltage for the first time, and an instruction to transmit a recalibration signal to the battery management apparatus connected to the corresponding online battery to readjust the charge state of the online battery.

According to another embodiment, the instruction to switch the at least one online battery to the offline state may include an instruction to determine whether any one of the plurality of online batteries being charged satisfies the predetermined target voltage; an instruction to, if an online battery satisfies the predetermined target voltage, transmit a charge rate control signal to a battery management apparatus connected to the online battery to adjust the charge rate of the online battery downward; an instruction to transmit a recalibration signal to the battery management apparatus connected to the online battery to readjust the charge state of the online battery; and an instruction to, if the online battery is fully charged, transmit a switch control signal to the battery management apparatus connected to the online battery to disconnect the connection of the online battery with the DC bus.

Meanwhile, the instruction to switch the at least one online battery to the offline state may be performed until all of the plurality of online batteries are switched to the offline state.

Furthermore, the at least one instruction may further include an instruction to switch at least one offline battery to an online state during a process of discharging the battery system.

Here, the instruction to switch the at least one offline battery to the online state may include an instruction to switch at least one offline battery for which cell balancing performance has been completed, to an online state.

Furthermore, the instruction to switch the at least one offline battery to the online state may include an instruction to switch a target offline battery to an online state when the battery system is in a discharge mode; and an instruction to sequentially switch a plurality of offline batteries, excluding the target offline battery, to an online state, afterwards.

H ere, the target offline battery may be a battery that is switched to an offline state last among the plurality of online batteries.

Furthermore, the instruction to sequentially switch the plurality of offline batteries to the online state may include an instruction to monitor a voltage of at least one offline battery; an instruction to obtain a reference voltage of at least one online battery; an instruction to compare difference between the reference voltage of the at least one online battery and a voltage of each offline battery; and an instruction to switch at least one of the offline batteries of which the difference falls into a predetermined voltage range, to an online state.

Me anwhile, the instruction to switch the at least one offline battery to an online state may be performed until all of the plurality of offline batteries are switched to an online state.

A ccording to another embodiment of the present disclosure, a battery control method, performed by battery control apparatus located in a battery system including a plurality of batteries, may include monitoring a voltage of a plurality of online batteries which are connected to a direct current (DC) bus and being charged, during a charging process of the battery system; switching at least one online battery, among the plurality of online batteries being charged, to an offline state by disconnecting the at least one corresponding online battery from the DC bus if the at least one corresponding online battery satisfies a predetermined target voltage; and controlling cell balancing for at least one offline battery that has been switched to the offline state.

Here, the controlling cell balancing may include controlling cell balancing of the at least one battery to be performed immediately after the at least one online battery is switched to an offline state.

In more detail, the controlling cell balancing may include transmitting a balancing mode switching signal to a battery management apparatus connected to the at least one offline battery, thereby controlling the battery management apparatus to perform cell balancing of the offline battery.

Meanwhile, according to an embodiment, the switching the at least one online battery to the offline state may include, if any one of the plurality of online batteries being charged satisfies the predetermined target voltage, determining whether a corresponding online battery is a battery that has arrived at the predetermined target voltage again; and transmitting a switch control signal to a battery management apparatus connected to the corresponding online battery to disconnect the connection of the corresponding online battery to the DC bus if the corresponding online battery has arrived at the predetermined target voltage again.

Furthermore, the switching the at least one online battery to the offline state may include transmitting a charge rate control signal to a battery management apparatus connected to a corresponding online battery to adjust the charge rate of the corresponding online battery downward if the corresponding online battery reaches a predetermined target voltage for the first time, and transmitting a recalibration signal to the battery management apparatus connected to the corresponding online battery to readjust the charge state of the online battery.

According to another embodiment, the switching the at least one online battery to the offline state may include determining whether any one of the plurality of online batteries being charged satisfies the predetermined target voltage; if an online battery satisfies the predetermined target voltage, transmitting a charge rate control signal to a battery management apparatus connected to the online battery to adjust the charge rate of the online battery downward; transmitting a recalibration signal to the battery management apparatus connected to the online battery to readjust the charge state of the online battery; and if the online battery is fully charged, transmitting a switch control signal to the battery management apparatus connected to the online battery to disconnect the connection of the online battery with the DC bus.

Meanwhile, the switching the at least one online battery to the offline state is performed until all of the plurality of online batteries are switched to the offline state.

Furthermore, the method may further include switching at least one offline battery to an online state during a process of discharging the battery system.

Here, the switching the at least one offline battery to the online state may include switching at least one offline battery for which cell balancing performance has been completed, to an online state.

Furthermore, the switching the at least one offline battery to the online state may include switching a target offline battery to an online state when the battery system is in a discharge mode; and sequentially switching a plurality of offline batteries, excluding the target offline battery, to an online state, afterwards.

Here, the target offline battery is a battery that is switched to an offline state last among the plurality of online batteries.

Furthermore, the sequentially switching the plurality of offline batteries to the online state may include monitoring a voltage of at least one offline battery; obtaining a reference voltage of at least one online battery; comparing difference between the reference voltage of the at least one online battery and a voltage of each offline battery; and switching at least one of the offline batteries of which the difference falls into a predetermined voltage range, to an online state.

Meanwhile, the switching the at least one offline battery to an online state may be performed until all of the plurality of offline batteries are switched to an online state.

### [Advantageous Effects]

According to the embodiments of the present invention as described above, the battery control apparatus switches the state of at least one online battery that has reached a target voltage to an offline state in a charge mode, thereby allowing charging of online state batteries excluding corresponding batteries to proceed continuously, and thus, charging efficiency of a battery system can be improved.

In addition, according to the embodiments of the present invention, the battery control apparatus can minimize the deviation between cells inside the battery by additionally performing cell-level balancing on offline batteries for which battery-level charging has been completed, thereby enabling precise battery charging and discharging control.

### [Brief Description of the Drawings]

FIG. 1 is a block diagram of a general energy storage system.
FIG. 2 is a block diagram of a battery system according to embodiments of the present invention.
FIG. 3 is an operational flowchart of a battery control method in a charging process according to an embodiment of the present invention.
FIG. 4 is an operational flowchart of a battery control method in a charging process according to another embodiment of the present invention.
FIG. 5 is a reference diagram for explaining a battery control method in a charging process according to embodiments of the present invention.
FIG. 6 is an operational flowchart of a battery control method in a discharging process according to embodiments of the present invention.
FIG. 7 is a reference diagram for explaining a battery control method in a discharging process according to embodiments of the present invention.
FIG. 8 is a block diagram of a battery control apparatus according to embodiments of the present invention.

100: battery
   200: battery management apparatus
300: battery control apparatus
810: processor
820: memory
830: transceiver
840: input interface device
850: output interface device
860: storage device

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a basic unit that serves to store power and a battery module refers to an assembly in which aplurality of battery cells is electrically connected.

A battery rack refers to a system of a single structure which is assembled by electrically connecting module units set by a battery manufacturer and may be monitored and controlled by a battery management apparatus/system (BMS). A battery rack may include several battery modules (or battery packs) and a battery protection unit or any other protection device.

A battery bank refers to a group of large-scale battery rack systems configured by connecting a plurality of battery racks in parallel. A bank BMS for a battery bank may monitor and control severalrack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

State of Charge (SOC) refers to a current state of charge of a battery, representedin percent points [%], and State of Health (SOH) may be a current condition of a battery compared to its ideal or original conditions, representedin percent points [%].

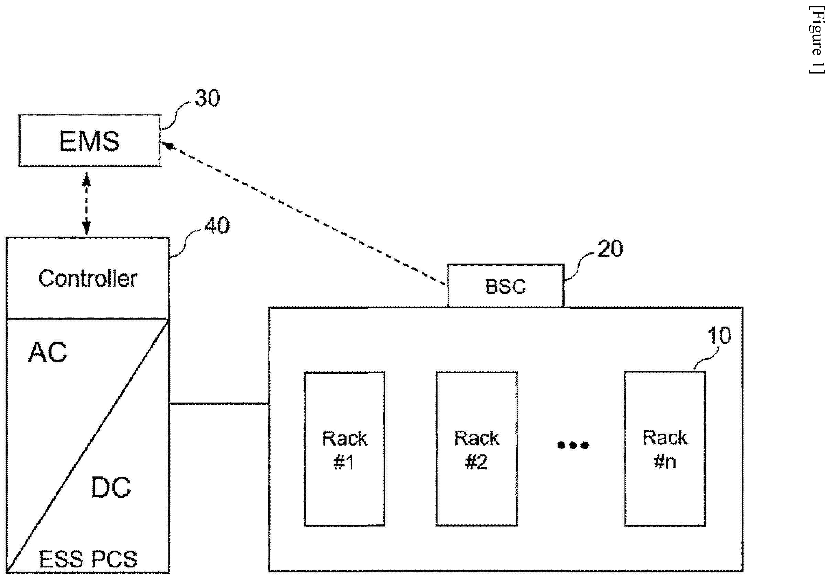

FIG. 1 is a block diagram of a general energy storage system.

In an energy storage system (ESS), a basic unit of battery for storing power is a battery cell. Typycally, a seris/parallel combination of battery cells may form a battery module and multiple battery module may form a battery rack. In other words, a battery rack as a series/parallel combination of battery modules may be abasic unit of a battery system. Here, a battery module may be referred to as a battery pack depending on a device or a system in which the battery is used.

Referring to FIG.1, a battery rack 10 may include multiple battery modules and a battery protection unit or any other protection device. A battery rack may be monitored and controlled through a rack battery management system (rack BMS). The RBMS may monitor a current, a voltage and a temperature of each battery rack to be managed, calculate a state of charge (SOC) of the battery based on monitoring result, and control charging and discharging.

Meanwhile, the battery protection unit (BPU) is a device for protecting the battery from abnormal current and fault current in a battery rack. The BPU may include a main contactor (MC), a fuse, a circuit breaker (CB), or a disconnect switch (DS). Here, the main contactor may include a positive main contactor and a negative main contactor. The BPU may control the battery system rack by rack by controlling the main contactor on/off according to control of the RBMS. The BPU may also protect the battery from short-circuit current by using a fuse when a short-circuit occurs. As such, a general battery system may be controlled through a protection device such as a BPU or a switch gear.

Meanwhile, a battery system controller (BSC) 20 may be located in each battery section which includes a plurality of batteries, peripheral circuits, and devices,so as to monitor and control objects such as a voltage, a current, a temperature, and a circuit breaker. The battery system controller may be a top-level controller of a bank-level battery system including a plurality of battery racks and is also used as a controller in a battery system with a multiple bank-level structure.

Furthermore, a power conversion system (PCS) 40 installed in each battery section may perform actual charging/discharging based on a charge/discharge command from an energy management system (EMS) 30. The power conversion system may include a power conversion unit (DC/AC inverter) and a controller. Meanwhile, the output of each BPU may be connected to a power generation device (e.g., phtovoltaic system) and the PCS 40 which is connected to a power grid, through a DC bus. In addition, the energy management system (EMS) 30 or a power management system (PMS) may manage the energy storage system in overall.

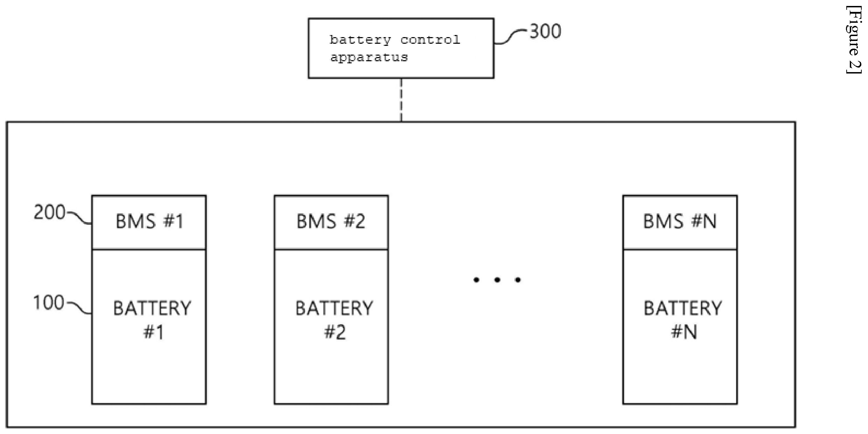

FIG. 2 is a block diagram of a battery system according to embodiments of the present invention.

Referring to FIG. 2, a battery system according to embodiments of the present invention may include a plurality of batteries 100, a plurality of battery management apparatuses 200 that are provided corresponding to each of the plurality of batteries and manage and control the corresponding batteries, and a battery control apparatus 300 that is connected to and interoperate with the plurality of battery management apparatuses 200.

The battery 100 may be a battery assembly including a plurality of unit cells that are electrically connected to each other. For example, the battery 100 may mean a battery rack, but the scope of the present invention is not limited thereto. In other words, the battery 100 according to the present invention may correspond to a battery module, a battery pack, or a battery bank.

The batteries 100 may be configured to be connected in parallel with each other. Here, each of the batteries 100 may be electrically connected to a direct current (DC) bus and connected in parallel with other batteries.

Each of the batteries 100 may include a switch arranged at an input/output terminal, and when the switch is switched from a closed state to an open state, the electrical connection with the DC bus is cut off and the parallel connection with another battery may be released. In contrast, when the switch of the battery 100 is switched from an open state to a closed state, the battery 100 may be electrically connected to the DC bus and may be connected in parallel with other batteries.

The battery management apparatus 200 may collect state information on a corresponding battery 100 and perform a predetermined control operation based on the collected state information, thereby managing and controlling the corresponding battery 100. More specifically, the battery management apparatus 200 may control charging and discharging of the battery and diagnose whether battery cells are faulty based on the state information of the battery. Here, the state information may include one or more of the voltage value and SOC value of the battery, and the voltage value and SOC value of each of the unit cells included in the battery.

The battery management apparatus 200 may control the operation of the switch provided at the input/output terminal of the battery 100.

Each of the battery management apparatus 200 may be connected to the battery control apparatus 300 through a network, transmit battery state information to the battery control apparatus 300, and receive a control command from the battery control apparatus 300 to operate. Here, the battery management apparatus 200 may receive a switch control signal for controlling the operation of the switch from the battery control apparatus 300 and control on/off operation of the switch according to the switch control signal.

The battery control apparatus 300 may monitor and control the operation status of each of the battery management apparatuses 200.

The battery control apparatus 300 may correspond to a battery system controller (BSC), an energy management system (EMS), or a power management system (PMS).

The battery control apparatus 300 may monitor the voltage of the online battery and the voltage of the offline battery during a process of charging and discharging at least one online battery by the battery management apparatus 200, and sequentially disconnect one or more batteries that have reached a predetermined target voltage from the DC bus.

The battery control apparatus 300 may perform a defined control process corresponding to the operation mode of the battery system.

The battery control apparatus 300 may monitor the voltage of each battery during a process of charging the batteries while the batteries are connected in parallel to the DC bus (online state), and sequentially remove the batteries that have reached a predetermined target voltage from the DC bus.

Afterwards, the battery control apparatus 300 may reconnect one or more selected target batteries to the DC bus and switch the selected target batteries to an online state.

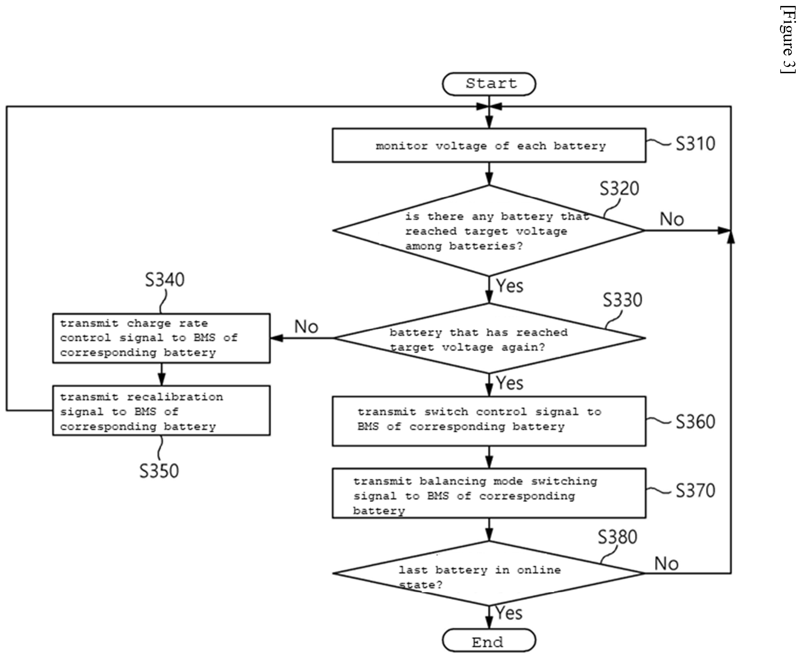

FIG. 3 is an operational flowchart of a battery control method in a charging process according to an embodiment of the present invention.

Referring to FIG. 3, the battery control method according to embodiments of the present invention may be performed by a battery control apparatus located in a battery system including a plurality of batteries. Here, the battery control apparatus may correspond to an upper control apparatus that is connected and interoperates with battery management apparatuses of each of the plurality of batteries. Additionally, the plurality of batteries may be provided online in an initial state.

The battery control apparatus may monitor a charge voltage of each of the online state batteries while the batteries are connected in parallel to a DC bus (S310). For example, the battery control apparatus may receive voltages of batteries or voltages of each of the unit cells from battery management apparatuses corresponding to each of online state batteries.

The battery control apparatus may determine whether there is a battery, among the online state batteries, that has reached a predetermined target voltage (S320). More specifically, the battery control apparatus may check whether the maximum voltage value among voltage values of the unit cells included in a specific battery among online state batteries reaches a target voltage.

Here, if there is a corresponding battery that has reached the predetermined target voltage among the online state batteries (Yes in S320), The battery control apparatus may check whether the corresponding battery is a battery that has reached the target voltage again (S330). For example, the battery control apparatus may check whether the corresponding battery is a battery that has reached the target voltage again by counting information on the battery that has reached the target voltage or receiving charge rate information from a battery management apparatus corresponding to the corresponding battery.

According to one embodiment, if the corresponding battery is not a battery that has reached the target voltage again (No in S330), in other words, if the corresponding battery is a battery that has reached the target voltage for the first time, the battery control apparatus may transmit a charge rate control signal to a battery management apparatus corresponding to the corresponding battery (S340). Accordingly, the battery management apparatus may adjust the charge voltage of the corresponding battery in order to adjust the charge rate (C-rate) of the corresponding battery downward. For example, the battery control apparatus may transmit a charge rate control signal to the battery management apparatus of the corresponding battery so that the battery is charged at 0.05 C-rate when one of the batteries in online state that is being charged at a charge rate of 0.5 C-rate reaches a predetermined target voltage. Accordingly, the battery management apparatus may adjust the charge voltage of the corresponding battery downward in order to adjust the charge rate (C-rate) of the battery downward. Here, the predetermined target voltage may be 3.6 V.

Thereafter, the battery control apparatus may transmit a recalibration signal to the battery management apparatus of the corresponding battery to readjust the charge state of the corresponding battery (S350). Accordingly, the charge state of the corresponding battery can be readjusted.

Afterwards, the battery control apparatus may return to step S310 and continue to monitor charge voltages of the batteries in online state.

Meanwhile, according to another embodiment, if the corresponding battery is a battery that has reached the target voltage again (Yes in S330), the battery control apparatus may transmit a switch control signal to a battery management apparatus of the corresponding battery (S360). Accordingly, the battery management apparatus may turn a switch connecting the corresponding battery and a DC bus to an open state. Accordingly, the corresponding battery may be disconnected from the DC bus and maintained in an offline state. Here, while steps S320 to S360 are being performed, batteries in an online state, excluding the corresponding battery, may be continuously charged at a preset charge rate (e.g., 0.5 C-rate) by the corresponding battery management apparatuses until a preset target voltage is reached.

Thereafter, the battery control apparatus may transmit a cell balancing mode switching signal to the battery management apparatus of the corresponding battery in the offline state (S370). For example, the battery control apparatus may transmit a mode switching signal to the battery management apparatus of the corresponding battery so that the corresponding battery is switched to a cell balancing mode when a predetermined time has elapsed from the time when the corresponding battery is switched to the offline state. Accordingly, the corresponding battery in the offline state may perform cell balancing under the control of the battery management apparatus connected to the corresponding battery. For example, the predetermined time may be 10 minutes. However, without being limited to what has been disclosed, the battery control apparatus may also transmit a cell balancing mode switching signal to the battery management apparatus managing the corresponding battery so that cell balancing can be performed as soon as the corresponding battery is removed from the DC bus, in other words, so that cell balancing can be performed immediately after the corresponding battery is switched to an offline state.

Thereafter, the battery control apparatus may check whether the corresponding battery is the last battery in an online state (S380).

Here, if the battery that has reached the target voltage is not the last online battery (No in S380), the battery control apparatus may repeat steps S310 to S380 until the last online battery.

In a typical battery system, when a voltage of a specific cell included in a battery reaches a predetermined target voltage during a charging process of a plurality of batteries, it is determined that the battery has satisfied the target voltage and thus, the charging process is terminated. Accordingly, even when other batteries except the corresponding battery are not charged to the predetermined target voltage, the charging process is stopped by the battery system, resulting in a disadvantage of reduced efficiency of the battery system.

In addition, during the charging process of the plurality of batteries, the battery that reaches the predetermined target voltage first has a disadvantage in that voltage deviation among unit cells within the corresponding battery is greater.

Meanwhile, the battery control apparatus according to an embodiment of the present invention can switch a battery that has reached a predetermined target voltage among the batteries in an online state to an offline state and continuously perform charging so that multiple online batteries except for the corresponding battery are charged to the target voltage.

In addition, the battery control apparatus according to an embodiment of the present invention may transmit a balancing execution signal to a battery management apparatus of the offline battery that has reached the target voltage. Accordingly, the corresponding offline battery is subject to cell balancing by the battery management apparatus, thereby minimizing the voltage deviation among cells, and thus improving charge efficiency of the battery system.

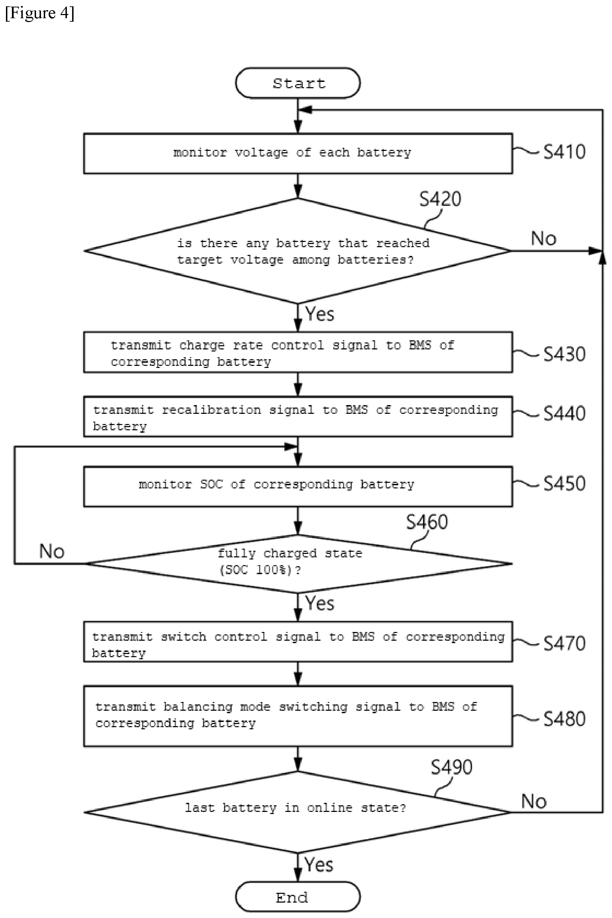

FIG. 4 is an operational flowchart of a battery control method in a charging process according to another embodiment of the present invention.

Referring to FIG. 4, the battery control apparatus may monitor the charging voltage of each of the batteries in the online state that are connected in parallel to the DC bus (S410).

The battery control apparatus may check whether there is a battery, among the batteries in the online state, that has reached a predetermined target voltage (S420). More specifically, the battery control apparatus may check whether the maximum voltage value among the voltage values of unit cells included in a specific battery among the batteries in the online state has reached a target voltage.

Here, if there is a battery among the batteries in the online state that has reached the predetermined target voltage (Yes in S420), the battery control apparatus may transmit a charge rate control signal to a battery management apparatus corresponding to the battery (S430). Accordingly, the battery management apparatus may adjust a charge voltage of the battery downward so that the charge rate (C-rate) of the battery is adjusted downward.

Thereafter, the battery control apparatus may transmit a recalibration signal to the battery management apparatus of the corresponding battery to readjust the charge state of the corresponding battery (S440). Accordingly, the charge state of the corresponding battery may be readjusted.

Thereafter, the battery control apparatus may monitor the charge state of the corresponding battery being charged (S450). Here, if the corresponding battery reaches a full charge state (S460), the battery control apparatus may transmit a switch control signal to the battery management apparatus corresponding to the corresponding battery (S470). Accordingly, the battery management apparatus may turn a switch connecting the corresponding battery and a DC bus to an open state. Accordingly, the corresponding battery may be disconnected from the DC bus and maintained in an offline state. Here, while steps S420 to S470 are being performed, batteries in the online state, excluding the corresponding battery, may be continuously charged at a predefined charge rate (e.g., 0.5 C-rate) by the battery management apparatuses corresponding to the batteries in the online state.

Thereafter, the battery control apparatus may transmit a cell balancing mode switching signal to the battery management apparatus of the corresponding battery in the offline state (S480). For example, the battery control apparatus may transmit a mode switching signal to the battery management apparatus of the corresponding battery so that the corresponding battery is switched to the cell balancing mode when a predetermined time has elapsed from the time when the corresponding battery is switched to the offline state. Accordingly, the corresponding battery in the offline state may perform cell balancing under control of the battery management apparatus connected to the corresponding battery. For example, the predetermined time may be 10 minutes. However, without being limited to what has been disclosed, the battery control apparatus may also transmit a cell balancing mode switching signal to the battery management apparatus managing the corresponding battery so that cell balancing can be performed as soon as the corresponding battery is removed from the DC bus, in other words, so that cell balancing can be performed immediately after the corresponding battery is switched to the offline state.

Thereafter, the battery control apparatus may check whether the corresponding battery is the last battery in the online state (S490).

Here, if the battery that has reached the target voltage is not the last online battery (No of S490), the battery control apparatus may repeatedly perform steps S410 to S480 until the last online battery.

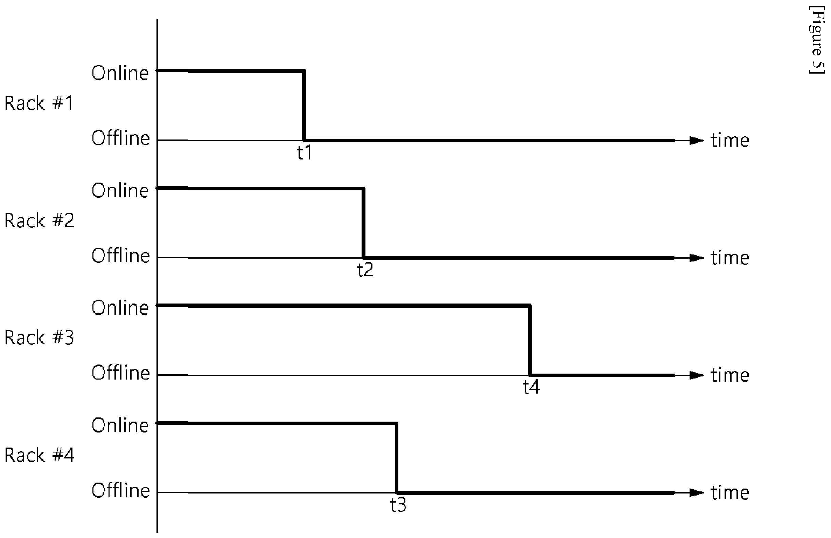

FIG. 5 is a reference diagram for explaining a battery control method in a charging process according to embodiments of the present invention.

Hereinafter, with reference to FIG. 5, a battery control method in a charge mode according to embodiments of the present invention will be explained using a battery system including four battery racks connected in parallel as an example.

The battery control apparatus may monitor the voltage of each of the racks (Rack #1 to #4) being charged in online state.

According to embodiments, if the maximum voltage value (hereinafter, maximum cell voltage value) among the voltage values of unit cells included in Rack #1 at time t1 reaches a target voltage (e.g., 3.6 V), the battery control apparatus may disconnect Rack #1 from the DC bus at time t1 and switch it to an offline state. Thereafter, the battery control apparatus may transmit a cell balancing mode switching signal to a battery management apparatus connected to Rack #1. Accordingly, Rack #1 may be cell balanced by the battery management apparatus.

Thereafter, if the maximum cell voltage value of Rack #2 reaches the target voltage at time t2, the battery control apparatus may disconnect Rack #2 from the DC bus at time t2 and switch it to an offline state. Here, the battery control apparatus may transmit a cell balancing mode switching signal to a battery management apparatus connected to Rack #2. Accordingly, Rack #2 may be cell balanced by the battery management apparatus.

Afterwards, if the maximum cell voltage value of Rack #4 reaches the target voltage at time t3, the battery control apparatus may switch Rack #4 to an offline state by disconnecting Rack #4 from the DC bus at time t3. Here, the battery control apparatus may transmit a cell balancing mode switching signal to a battery management apparatus connected to Rack #4. Accordingly, Rack #4 may be cell balanced by the battery management apparatus.

Thereafter, if the maximum cell voltage value of Rack #3 reaches the target voltage at time t4, the battery control apparatus may switch Rack #3 to an offline state by disconnecting Rack #3 from the DC bus at time t4. Here, the battery control apparatus may transmit a cell balancing mode switching signal to a battery management apparatus connected to Rack #3. Accordingly, Rack #3 may be cell balanced by the battery management apparatus.

Afterwards, when the charging process is stopped, the battery control apparatus may standby until a discharging process of the battery system is in progress.

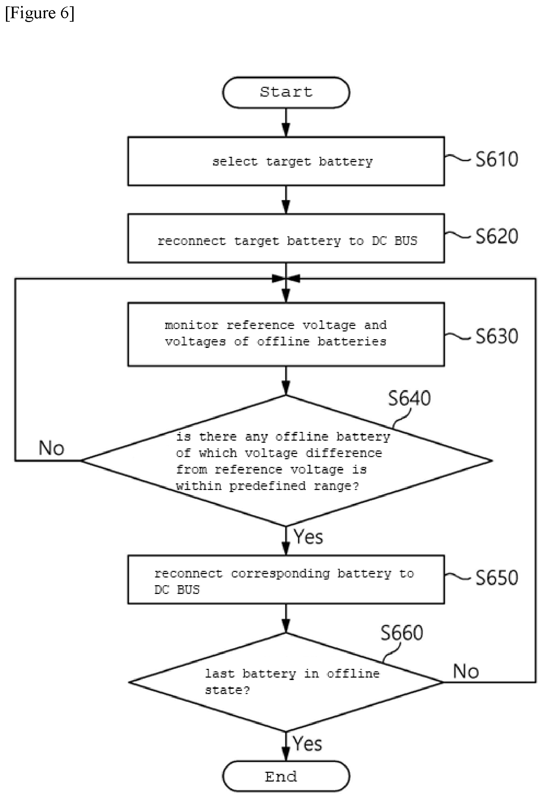

FIG. 6 is an operational flowchart of a battery control method in a discharge mode according to embodiments of the present invention.

Referring to FIG. 6, if the battery system is switched to a discharge mode when all batteries are offline, the battery control apparatus may select one of a plurality of offline batteries as a target battery (S610). For example, the target battery may be the last battery switched to the offline state among a plurality of online batteries.

Thereafter, the battery control apparatus may reconnect the target battery in an offline state to the DC bus (S620) and switch it to an online state. More specifically, the battery control apparatus may transmit a switch control signal to the battery management apparatus of the target battery so that a switch connecting the offline battery and the DC bus is switched to the ON state (closed state). Accordingly, the target battery may be reconnected to the DC bus.

Thereafter, the battery control apparatus may monitor a reference voltage of the battery system and the voltages of the remaining offline batteries excluding the target battery during a process of discharging one or more online batteries (S630). Here, the reference voltage of the battery system may be defined as an average voltage of the online batteries.

Afterwards, the battery control apparatus may check whether there is an offline battery, among the offline batteries, whose voltage difference from the reference voltage of the battery system is within a predefined range (S640).

If there is a specific offline battery whose voltage difference from the reference voltage of the battery system is within the predefined range (Yes in S640), in other words, if the difference between the voltage of the specific offline battery and the average voltage of online batteries is within the predefined range, the battery control apparatus may switch the corresponding offline battery to an online state (S650). More specifically, the battery control apparatus may transmit a switch control signal to the battery management apparatus of the corresponding offline battery to turn the switch connecting the corresponding offline battery and the DC bus to an on state (closed state). Accordingly, the corresponding offline battery may be reconnected to the DC bus and switched to an online state.

Meanwhile, if the corresponding battery that has reached the target voltage is not the last battery in the offline state (No in S660), the battery control apparatus may repeat steps S610 to S650 until the last battery in the offline state is switched to an online state.

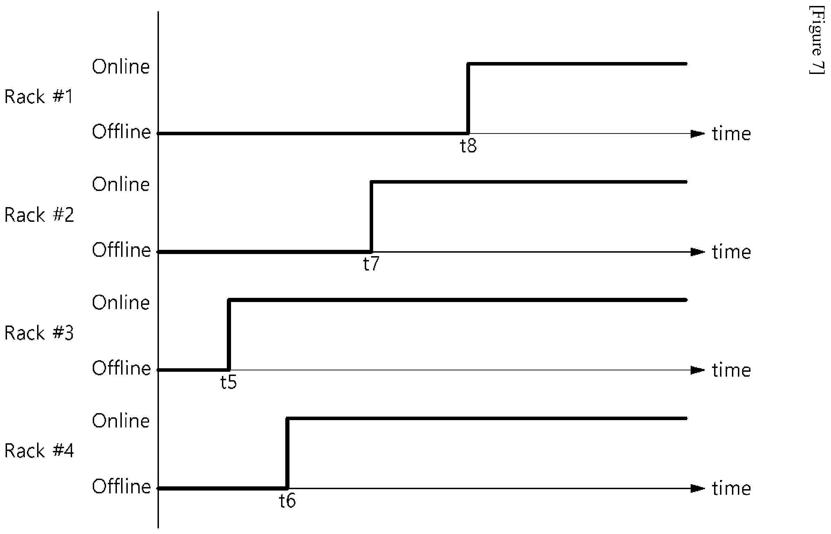

FIG. 7 is a reference diagram for explaining a battery control method in a discharge mode according to embodiments of the present invention.

Hereinafter, referring to FIG. 7, a battery control method in a discharge mode according to an embodiment of the present invention will be explained using a battery system including four battery racks connected in parallel as an example.

According to the embodiment, at time t5, when the battery system is switched to a discharge mode, the battery control apparatus may switch Rack #3, which was switched to an offline state last during a charging process, among the battery racks (Rack #1 to #4) in offline state, to an online state.

Thereafter, the battery control apparatus may monitor the voltage of each of the battery racks (Rack #1 to #4) during a process of discharging Rack #3 which has been switched to the online state. Here, the battery racks (Rack #1 to #4) may be racks for which cell balancing has been completed.

Thereafter, when the voltage of Rack #3 in the online state gradually decreases and reaches the voltage of Rack #4 at time t6, the battery control apparatus may switch Rack #4, which has been in the offline state, to an online state at time t6.

Thereafter, when the voltages of Rack #3 and Rack #4 in the online state gradually decrease and reach the voltage of Rack #2 at time t7, the battery control apparatus may switch Rack #2, which has been in the offline state, to an online state at time t7.

After that, the voltages of Rack #2, Rack #3, and Rack #4, which are online state, gradually decrease, and when they reach the voltage of Rack #1 at time t8, the battery control apparatus may switch Rack #1, which has been offline, to an online state at time t8.

Accordingly, all battery racks (Rack #1 to #4) that have been switched to online may be connected in parallel to the DC bus and discharged.

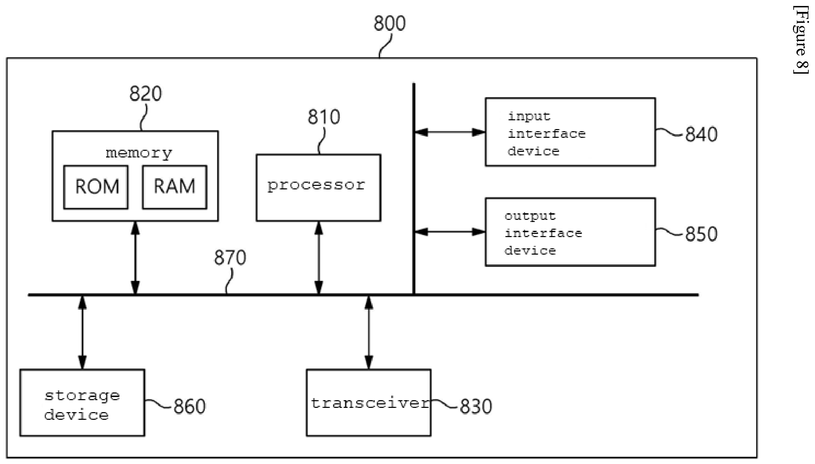

FIG. 8 is a block diagram of a battery control apparatus according to embodiments of the present invention.

Referring to FIG. 8, The battery control apparatus according to embodiments of the present invention may include at least one processor 810, a memory 820 that stores at least one instruction executed by the processor, and a transceiver 830 that is connected to a network and performs communication.

H ere, the at least one instruction may include an instruction to monitor a voltage of a plurality of online batteries which are connected to a direct current (DC) bus and being charged, during a charging process of the battery system; an instruction to switch at least one online battery, among the plurality of online batteries being charged, to an offline state by disconnecting the at least one corresponding online battery from the DC bus if the at least one corresponding online battery satisfies a predetermined target voltage; and an instruction to control cell balancing for at least one offline battery that has been switched to the offline state.

Here, the instruction to control cell balancing may include an instruction to control cell balancing of the at least one battery to be performed immediately after the at least one online battery is switched to an offline state.

In more detail, the instruction to control cell balancing may include an instruction to transmit a balancing mode switching signal to a battery management apparatus connected to the at least one offline battery, thereby controlling the battery management apparatus to perform cell balancing of the offline battery.

Meanwhile, according to an embodiment, the instruction to switch the at least one online battery to the offline state may include an instruction to, if any one of the plurality of online batteries being charged satisfies the predetermined target voltage, determine whether a corresponding online battery is a battery that has arrived at the predetermined target voltage again; and an instruction to transmit a switch control signal to a battery management apparatus connected to the corresponding online battery to disconnect the connection of the corresponding online battery to the DC bus if the corresponding online battery has arrived at the predetermined target voltage again.

Furthermore, the instruction to switch the at least one online battery to the offline state may include an instruction to transmit a charge rate control signal to a battery management apparatus connected to a corresponding online battery to adjust the charge rate of the corresponding online battery downward if the corresponding online battery reaches a predetermined target voltage for the first time, and an instruction to transmit a recalibration signal to the battery management apparatus connected to the corresponding online battery to readjust the charge state of the online battery.

According to another embodiment, the instruction to switch the at least one online battery to the offline state may include an instruction to determine whether any one of the plurality of online batteries being charged satisfies the predetermined target voltage; an instruction to, if an online battery satisfies the predetermined target voltage, transmit a charge rate control signal to a battery management apparatus connected to the online battery to adjust the charge rate of the online battery downward; an instruction to transmit a recalibration signal to the battery management apparatus connected to the online battery to readjust the charge state of the online battery; and an instruction to, if the online battery is fully charged, transmit a switch control signal to the battery management apparatus connected to the online battery to disconnect the connection of the online battery with the DC bus.

Meanwhile, the instruction to switch the at least one online battery to the offline state may be performed until all of the plurality of online batteries are switched to the offline state.

Furthermore, the at least one instruction may further include an instruction to switch at least one offline battery to an online state during a process of discharging the battery system.

Here, the instruction to switch the at least one offline battery to the online state may include an instruction to switch at least one offline battery for which cell balancing performance has been completed, to an online state.

Furthermore, the instruction to switch the at least one offline battery to the online state may include an instruction to switch a target offline battery to an online state when the battery system is in a discharge mode; and an instruction to sequentially switch a plurality of offline batteries, excluding the target offline battery, to an online state, afterwards.

Her e, the target offline battery may be a battery that is switched to an offline state last among the plurality of online batteries.

Furthermore, the instruction to sequentially switch the plurality of offline batteries to the online state may include an instruction to monitor a voltage of at least one offline battery; an instruction to obtain a reference voltage of at least one online battery; an instruction to compare difference between the reference voltage of the at least one online battery and a voltage of each offline battery; and an instruction to switch at least one of the offline batteries of which the difference falls into a predetermined voltage range, to an online state.

M eanwhile, the instruction to switch the at least one offline battery to an online state may be performed until all of the plurality of offline batteries are switched to an online state.

T he battery control apparatus 800 may further include an input interface device 840, an output interface device 850, a storage device 860, etc. Respective components included in the battery control apparatus 800 may be connected by a bus 870 and can communicate with each other.

Here, the processor 810 may mean a central processing unit (CPU), a graphics processing unit (GPU), or a dedicated processor on which methods according to embodiments of the present invention are performed. The memory 820 or storage unit 860 may include at least one of a volatile storage medium and a non-volatile storage medium. For example, the memory 820 may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A battery control apparatus located in a battery system including a plurality of batteries, the battery control apparatus comprising:
at least one processor; and
a memory configured to store at least one instruction executed by the at least one processor,
wherein the at least one instruction includes:
an instruction to monitor a voltage of a plurality of online batteries which are connected to a DC bus and being charged, during a charging process of the battery system;
an instruction to switch at least one online battery, among the plurality of online batteries being charged, to an offline state by disconnecting the at least one corresponding online battery from the DC bus if the at least one corresponding online battery satisfies a predetermined target voltage; and
an instruction to control cell balancing for at least one offline battery that has been switched to the offline state.

2. The battery control apparatus of claim 1, wherein the instruction to control cell balancing includes:
an instruction to control cell balancing of the at least one battery to be performed immediately after the at least one online battery is switched to an offline state.

3. The battery control apparatus of claim 1, wherein the instruction to control cell balancing includes:
an instruction to transmit a balancing mode switching signal to a battery management apparatus connected to the at least one offline battery, thereby controlling the battery management apparatus to perform cell balancing of the offline battery.

4. The battery control apparatus of claim 1, wherein the instruction to switch the at least one online battery to the offline state includes:
an instruction to, if any one of the plurality of online batteries being charged satisfies the predetermined target voltage, determine whether a corresponding online battery is a battery that has arrived at the predetermined target voltage again; and
an instruction to transmit a switch control signal to a battery management apparatus connected to the corresponding online battery to disconnect the connection of the corresponding online battery to the DC bus if the corresponding online battery has arrived at the predetermined target voltage again.

5. The battery control apparatus of claim 4, wherein the instruction to switch the at least one online battery to the offline state includes:
an instruction to transmit a charge rate control signal to a battery management apparatus connected to a corresponding online battery to adjust the charge rate of the corresponding online battery downward if the corresponding online battery reaches a predetermined target voltage for the first time; and
an instruction to transmit a recalibration signal to the battery management apparatus connected to the corresponding online battery to readjust the charge state of the online battery.

6. The battery control apparatus of claim 1, wherein the instruction to switch the at least one online battery to the offline state includes:
an instruction to determine whether any one of the plurality of online batteries being charged satisfies the predetermined target voltage;
an instruction to, if an online battery satisfies the predetermined target voltage, transmit a charge rate control signal to a battery management apparatus connected to the online battery to adjust the charge rate of the online battery downward;
an instruction to transmit a recalibration signal to the battery management apparatus connected to the online battery to readjust the charge state of the online battery; and
an instruction to, if the online battery is fully charged, transmit a switch control signal to the battery management apparatus connected to the online battery to disconnect the connection of the online battery with the DC bus.

7. The battery control apparatus of claim 1, wherein the instruction to switch the at least one online battery to the offline state is performed until all of the plurality of online batteries are switched to the offline state.

8. The battery control apparatus of claim 1, wherein the at least one instruction further includes:
an instruction to switch at least one offline battery to an online state during a process of discharging the battery system.

9. The battery control apparatus of claim 8, wherein the instruction to switch the at least one offline battery to the online state includes:
an instruction to switch at least one offline battery for which cell balancing performance has been completed, to an online state.

10. The battery control apparatus of claim 8, wherein the instruction to switch the at least one offline battery to the online state includes:
an instruction to switch a target offline battery to an online state when the battery system is in a discharge mode; and
an instruction to sequentially switch a plurality of offline batteries, excluding the target offline battery, to an online state, afterwards.

11. The battery control apparatus of claim 10, wherein the target offline battery is a battery that is switched to an offline state last among the plurality of online batteries.

12. The battery control apparatus of claim 10, wherein the instruction to sequentially switch the plurality of offline batteries to the online state includes:
an instruction to monitor a voltage of at least one offline battery;
an instruction to obtain a reference voltage of at least one online battery;
an instruction to compare difference between the reference voltage of the at least one online battery and a voltage of each offline battery; and
an instruction to switch at least one of the offline batteries of which the difference falls into a predetermined voltage range, to an online state.

13. The battery control apparatus of claim 8, wherein the instruction to switch the at least one offline battery to an online state is performed until all of the plurality of offline batteries are switched to an online state.

14. A battery control method performed by a battery control apparatus located in a battery system including a plurality of batteries, the battery control method comprising:
monitoring a voltage of a plurality of online batteries which are connected to a DC bus and being charged, during a charging process of the battery system;
switching at least one online battery, among the plurality of online batteries being charged, to an offline state by disconnecting the at least one corresponding online battery from the DC bus if the at least one corresponding online battery satisfies a predetermined target voltage; and
controlling cell balancing for at least one offline battery that has been switched to the offline state.

15. The battery control method of claim 14, wherein the controlling cell balancing includes:
controlling cell balancing of the at least one battery to be performed immediately after the at least one online battery is switched to an offline state.

16. The battery control method of claim 14, wherein the controlling cell balancing includes:
transmitting a balancing mode switching signal to a battery management apparatus connected to the at least one offline battery, thereby controlling the battery management apparatus to perform cell balancing of the offline battery.

17. The battery control method of claim 14, wherein the switching the at least one online battery to the offline state includes:
if any one of the plurality of online batteries being charged satisfies the predetermined target voltage, determining whether a corresponding online battery is a battery that has **arrived** at the predetermined target voltage **again**; and
transmitting a switch control signal to a battery management apparatus connected to the corresponding online battery to disconnect the connection of the corresponding online battery to the DC bus if the corresponding online battery has **arrived** at the predetermined target voltage **again**.

18. The battery control method of claim 17, wherein the switching the at least one online battery to the offline state includes:
transmitting a charge rate control signal to a battery management apparatus connected to a corresponding online battery to adjust the charge rate of the corresponding online battery downward if the corresponding online battery reaches a predetermined target voltage for the first time, and
transmitting a recalibration signal to the battery management apparatus connected to the corresponding online battery to readjust the charge state of the online battery.

19. The battery control method of claim 14, wherein the switching the at least one online battery to the offline state includes:
determining whether any one of the plurality of online batteries being charged satisfies the predetermined target voltage;
if an online battery satisfies the predetermined target voltage, transmitting a charge rate control signal to a battery management apparatus connected to the online battery to adjust the charge rate of the online battery downward;
transmitting a recalibration signal to the battery management apparatus connected to the online battery to readjust the charge state of the online battery; and
if the online battery is fully charged, transmitting a switch control signal to the battery management apparatus connected to the online battery to disconnect the connection of the online battery with the DC bus.

20. The battery control method of claim 14, wherein the switching the at least one online battery to the offline state is performed until all of the plurality of online batteries are switched to the offline state.

21. The battery control method of claim 14, further comprising:
switching at least one offline battery to an online state during a process of discharging the battery system.

22. The battery control method of claim 21, wherein the switching the at least one offline battery to the online state includes:
switching at least one offline battery for which cell balancing performance has been completed, to an online state.

23. The battery control method of claim 21, wherein the switching the at least one offline battery to the online state includes:
switching a target offline battery to an online state when the battery system is in a discharge mode; and
sequentially switching a plurality of offline batteries, excluding the target offline battery, to an online state, afterwards.

24. The battery control method of claim 23, wherein the target offline battery is a battery that is switched to an offline state last among the plurality of online batteries.

25. The battery control method of claim 23, the sequentially switching the plurality of offline batteries to the online state includes:
monitoring a voltage of at least one offline battery;
obtaining a reference voltage of at least one online battery;
comparing difference between the reference voltage of the at least one online battery and a voltage of each offline battery; and
switching at least one of the offline batteries of which the difference falls into a predetermined voltage range, to an online state.

26. The battery control method of claim 21, wherein the switching the at least one offline battery to an online state is performed until all of the plurality of offline batteries are switched to an online state.
